# EUROPÄISCHE PATENTANMELDUNG

(11) **EP 0 891 043 A2**
(43) Veröffentlichungstag der Anmeldung: **13.01.1999**
(21) Anmeldenummer: 98112316.9
(22) Anmeldetag: 02.07.1998
(51) Int. Cl.: H03K 17/687

(54) **Schaltungsanordnung mit einer ersten Steuereinheit**

(30) Priorität: 10.07.1997 DE 19730215
(71) Anmelder: Dialog Semiconductor GmbH, 73230 Kirchheim (DE)
(72) Erfinder: Knödgen, Horst, Dipl.-Ing, 80997 München (DE)
(74) Vertreter: Prietsch, Reiner, Dipl.-Ing.

(57) **Zusammenfassung**

Beschrieben wird eine Schaltungsanordnung mit einer ersten Steuereinheit zur Ansteuerung eines ersten Halbleiterschalters und mit einer zweiten Steuereinheit zur Ansteuerung eines zweiten Halbleiterschalters, wobei ein Schaltungsausgang über den ersten Halbleiterschalter mit einem ersten Spannungsversorgungsanschluß und über den zweiten Halbleiterschalter mit einem zweiten Spannungsversorgungsanschluß verbunden ist. Zur Spannungsversorgung der ersten Steuereinheit ist eine Betriebsspannungsquelle und zur Spannungsversorgung der zweiten Steuereinheit ein wiederaufladbarer Energiespeicher vorgesehen. Die Betriebsspannungsquelle ist mit einem Anschluß an den ersten Spannungsversorgungsanschluß und der Energiespeicher mit einem Anschluß an den Schaltungsausgang angeschlossen und die Steuereinheiten sind über ein durch die erste Steuereinheit schaltbares Schaltelement miteinander verbunden, über welches, vorzugsweise bei geschlossenem ersten Halbleiterschalter und offenem zweiten Halbleiterschalter, ein Strom zum Aufladen des Energiespeichers und zur Übertragung von Steuerinformationen von der ersten Steuereinheit der zweiten Steuereinheit zuführbar ist.

## Beschreibung

Die Erfindung betrifft eine Schaltungsanordnung gemäß dem Oberbegriff des Patentanspruchs 1.

Eine derartige Schaltungsanordnung ist beispielsweise aus der DE 34 15 011 A1 bekannt. Die dort beschriebene Schaltungsanordnung weist zwei als MOS-Transistoren ausgeführte Halbleiterschalter in Halbbrückenschaltung auf, welche jeweils einen Spannungsversorgungsanschluß einer Versorgungsspannungsquelle mit einem Schaltungsausgang verbinden und welche durch jeweils eine Steuereinheit gegenphasig, d. h. Im Gegentakt angesteuert werden.

Der wesentliche Nachteil dieser Schaltungsanordnung besteht darin, daß zur Steuerung der Steuereinheiten Steuersignale mit unterschiedlichen Spannungspegeln benötigt werden, die, insbesondere bei einer hohen Versorgungsspannung zwischen den Spannungsversorgungsanschlüssen, nicht mit kostengünstigen Schaltungsmitteln generierbar sind.

Der Erfindung liegt die Aufgabe zugrunde, eine Schaltungsanordnung gemäß dem Oberbegriff des Patentanspruchs 1 anzugeben, deren Steuereinheiten integrierbar und mit geringem Schaltungsaufwand steuerbar sind und die auch mit einer hohen Versorgungsspannung zwischen den Spannungsversorgungsanschlüssen betreibbar ist.

Die Aufgabe wird durch die kennzeichnenden Merkmale des Patentanspruchs 1 gelöst. Vorteilhafte Weiterbildungen und Ausgestaltungen ergeben sich aus den Unteransprüchen.

Erfindungsgemäß wird die erste Steuereinheit aus einer Betriebsspannungsquelle und die zweite Steuereinheit aus einem wiederaufladbaren Energiespeicher - vorzugsweise aus einem Kondensator - mit Spannung versorgt. Die Betriebsspannungsquelle ist hierzu an die erste Steuereinheit und der Energiespeicher an die zweite Steuereinheit angeschlossen. Des weiteren ist die Betriebsspannungsquelle mit einem Anschluß an den ersten Versorgungsanschluß und der Energiespeicher mit einem Anschluß an den Schaltungsausgang der Schaltungsanordnung angeschlossen. Der Schaltungsausgang hat für die zweite Steuereinheit somit die Wirkung eines Bezugspotentialanschlusses, an dem ein schwimmendes Bezugspotential ansteht. Um den Energiespeicher aufzuladen und Steuerinformationen von der ersten Steuereinheit zur zweiten Steuereinheit zu übertragen, wird von der ersten Steuereinheit ein Strom bereitgestellt, der der zweiten Steuereinheit über eine die Steuereinheiten miteinander verbindende Schalteinheit, vorzugsweise über eine Diode, zugeführt wird. Das Schaltelement läßt sich hierzu durch die erste Steuereinheit, vorzugsweise während der Zeit, in der der erste Halbleiterschalter geschlossen und der zweite Halbleiterschalter offen ist, entsprechend ein- und ausschalten und ist bei offenem ersten Halbleiterschalter und geschlossenem zweiten Halbleiterschalter offen, um die Steuereinheiten voneinander galvanisch zu entkoppeln.

Vorteilhafterweise wird der durch das Schaltelement fließende Strom aus zwei von der ersten Steuereinheit nacheinander bereitgestellten Teilströmen - einem Ladestrom zum Aufladen des Energiespeichers und einem Signalstrom zur Übertragung der Steuerinformationen - zusammengesetzt und in der zweiten Steuereinheit anhand seines durch die erste Steuereinheit festgelegten Signalverlaufs, beispielsweise anhand seiner Amplitude oder der fest vorgegebenen Reihenfolge seiner Signalflanken, ausgewertet, um ihn entweder als Ladestrom oder als Signalstrom zu identifizieren.

Die erfindungsgemäße Schaltungsanordnung vereinigt folgende Vorteile in sich:
- Sie ist einfach und kostengünstig herstellbar und läßt sich in einer Vielzahl von Anwendungen, beispielsweise in elektronischen Vorschaltgeräten für Halogenlampen oder Leuchtstoffröhren, in Gleichstrom-Gleichstrom-Wandlern oder in Motorsteueranordnungen, als Treiber für Halbleiterschalter in Halbbrückenschaltung einsetzen.
- Als Halbleiterschalter sind Transistoren, insbesondere Leistungstransistoren, vorzugsweise Feldeffekt- oder IGB-(insulated Gate Bipolar)-Transistoren, einsetzbar.
- Bei einer hohen Versorgungsspannung zwischen den Versorgungsspannungsanschlüssen müssen lediglich die Halbleiterschalter und das Schaltelement eine hohe Spannungsfestigkeit aufweisen.
- Die Steuereinheiten lassen sich in Standardtechnologien auf jeweils einen oder auf einen gemeinsamen Halbleiterchip integrieren. Im Falle der Integration auf getrennte Halbleiterchips lassen sich diese beispielsweise mit einem Isolierkleber auf einen gemeinsamen Träger fixieren und in ein gemeinsames Gehäuse vergießen.

Die Erfindung wird im folgenden anhand von Ausführungsbeispielen unter Bezugnahme auf die Figuren näher beschrieben. Es zeigen:
- Figur 1:: ein Prinzipschaltbild der erfindungsgemäßen Schaltungsanordnung,
- Figur 2:: ein Detailschaltbild der Schaltungsanordnung aus Figur 1,
- Figur 3:: Zeitdiagramme für verschiedene Signale der Schaltungsanordnung aus Figur 2.

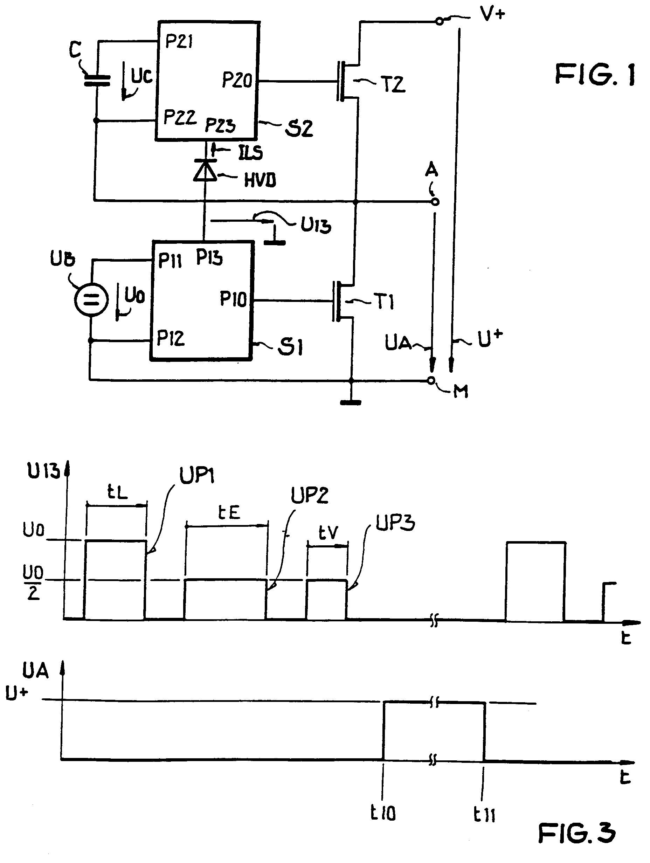

Gemäß Figur 1 sind die Steuereinheiten S1, S2 auf jeweils einen Halbleiterchip integriert und weisen mit den Anschlußpins P10, P13 bzw. P20, P23 jeweils zwei Steueranschlüsse und mit den Anschlußpins P11, P12 bzw. P21, P22 jeweils zwei Versorgungsanschlüsse zur Spannungsversorgung auf. Die erste Steuereinheit S1 fungiert als Mastereinheit und die zweite Steuereinheit S2 als durch die Mastereinheit gesteuerte Slaveeinheit. An die Anschlußpins P11 und P12 der ersten Steuereinheit S1 ist die Betriebsspannungsquelle UB angeschlossen - deren Betriebsspannung U0 beträgt beispielsweise 10 V - und an die Anschlußpins P21 und P22 der zweiten Steuereinheit S2 ist der als Kondensator ausgebildete Energiespeicher C angeschlossen. Der Anschlußpin P12 ist ferner mit dem ersten Spannungsversorgungsanschluß M, beispielsweise mit einem Masseanschluß, und der Anschlußpin P22 mit dem Schaltungsausgang A verbunden.

Die Halbleiterschalter T1, T2 sind im vorliegenden Beispiel als n-Kanal MOS-Leistungstransistoren ausgebildet, sie können jedoch auch als Bipolartransistoren ausgebildet sein. Der erste Transistor T1 ist dabei mit seinem Gate-Anschluß an den Anschlußpin P10 der ersten Steuereinheit S1, mit seinem Drain-Anschluß an den Schaltungsausgang A und mit seinem Source-Anschluß an den ersten Spannungsversorgungsanschluß M angeschlossen und der zweite Transistor T2 mit seinem Gate-Anschluß an den Anschlußpin P20 der zweiten Steuereinheit S2, mit seinem Drain-Anschluß an den zweiten Spannungsversorgungsanschluß V+ und mit seinem Source-Anschluß an den Schaltungsausgang A angeschlossen. Zwischen die Spannungsversorgungsanschlüsse V+, M wird die Versorgungsspannung U+ angelegt, welche beispielsweise 400 V beträgt. Zwischen dem Schaltungsausgang A und dem ersten Spannungsversorgungsanschluß M liegt dann die Ausgangsspannung UA an, die einer in der Figur nicht gezeigten und an den Schaltungsanschluß A anzuschließenden Last zugeführt wird.

Die Halbleiterschalter T1, T2 werden durch die Steuereinheiten S1, S2 derart gesteuert, daß sie nicht beide gleichzeitig geschlossen sind, d. h. sie werden entweder im Gegentakt wiederholt geöffnet und geschlossen oder zur Deaktivierung der Schaltungsanordnung beide geöffnet. Die Steuereinheiten S1, S2 müssen daher zueinander synchronisiert werden. Diese Synchronisierung erfolgt über das als Diode HVD ausgeführte Schaltelement, das anodenseitig mit dem Anschlußpin P13 und kathodenseitig mit dem Anschlußpin P23 verbunden ist. Aufgrund der hohen Versorgungsspannung U+ ist die Diode HVD als Hochvolt-Diode ausgebildet, d. h. als Diode mit hoher Spannungsfestigkeit in Sperrichtung.

Bei geschlossenem ersten Halbleiterschalter T1 und offenem zweiten Halbleiterschalter T2 nimmt die Ausgangsspannung UA ihren minimalen Wert an, der nahezu 0 V beträgt. Bei offenem ersten Halbleiterschalter T1 und geschlossenem zweiten Halbleiterschalter T2 nimmt sie hingegen ihren maximalen Wert an, der etwa gleich der Versorgungsspannung U+ ist. In diesem Fall sind die Potentiale an sämtlichen Anschlußpins P20 ... P23 der zweiten Steuereinheit S2 wesentlich höher als die Potentiale an den Anschlußpins P10 ... P13 der ersten Steuereinheit S1, so daß die Diode HVD in Sperrichtung vorgespannt ist. Die Steuereinheiten S1, S2 sind dann voneinander galvanisch entkoppelt. Bei minimaler Ausgangsspannung UA läßt sich die Diode HVD durch die von der ersten Steuereinheit S1 am Anschlußpin P13 bereitgestellte Steuerspannung U13 in Durchlaßrichtung vorspannen, um den Strom ILS von der ersten Steuereinheit S1 der zweiten Steuereinheit S2 zuzuführen. Mit dem Strom ILS werden dabei der Kondensator C aufgeladen und Steuerinformationen über die Schaltzeitpunkte des zweiten Halbleiterschalters T2 von der ersten zur zweiten Steuereinheit übertragen. Er wird aus zwei bei minimaler Ausgangsspannung UA von der ersten Steuereinheit S1 am Anschlußpin P13 abwechselnd bereitgestellten Teilströmen - dem zum Aufladen des Kondensators C erforderlichen Ladestrom IL und dem die Steuerinformationen enthaltenden Signalstrom IS - zusammengesetzt, die in der zweiten Steuereinheit S2 nach einem vorgegebenen Kriterium, beispielsweise anhand ihrer Amplitude oder der fest vorgegebenen zeitlichen Reihenfolge ihrer Signalflanken, eindeutig identifizierbar sind.

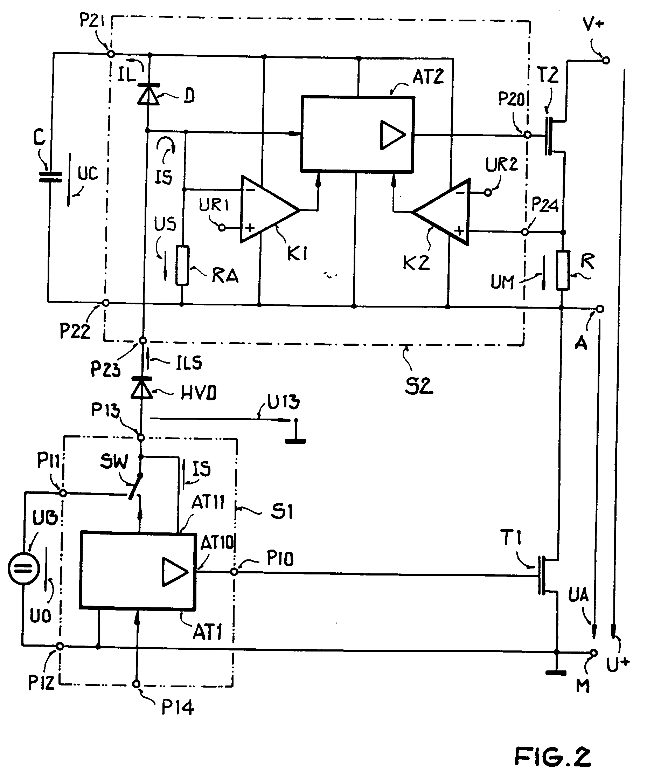

Beim Ausführungsbeispiel gemäß Figur 2 werden der Ladestrom IL und der Signalstrom IS anhand ihrer Amplitude identifiziert. Bei diesem Ausführungsbeispiel weist die erste Steuereinheit S1 eine aus der Betriebsspannungsquelle UB gespeiste Auswerte/Treibereinheit AT1 auf, die den ersten Transistor T1 über einen mit dem Anschlußpin P10 verbundenen Treiberausgang AT10 ansteuert und die über einen weiteren Anschlußpin P14 oder über einen Datenbus Systeminformationen zur Steuerung der Transistoren T1, T2 erhält. Die erste Steuereinheit S1 weist ferner einen durch die Auswerte/Treibereinheit AT1 angesteuerten Schalter SW auf, über den der Anschlußpin P13 mit dem Anschlußpin P11 verbunden ist. Der Anschlußpin P13 ist zudem mit einem zur Abgabe des Signalstromes IS vorgesehenen Stromausgang AT11 der Auswerte/Treibereinheit AT1 verbunden.

Die zweite Steuereinheit S2 weist eine Entkopplungsdiode D, einen Ableitwiderstand RA, zwei Komparatoren K1, K2 sowie eine Auswerte/Treibereinheit AT2 auf, wobei der Anschlußpin P23 über die Entkopplungsdiode D mit dem Anschlußpin P21 sowie über den Ableitwiderstand RA mit dem Anschlußpin P22 verbunden ist und den Komparatoren K1, K2 und der Auswerte/Treibereinheit AT2 zur Spannungsversorgung die im Kondensator C gespeicherte Spannung UC zugeführt wird. Die Auswerte/Treibereinheit AT2 wird über den Anschlußpin P23 und durch die Komparatoren K1, K2 angesteuert und steuert ihrerseits über den Anschlußpin P20 den zweiten Transistor T2 an.

Die erste Steuereinheit S1 liefert am Anschlußpin P13 die Steuerspannung U13, die gemäß Figur 3 während der Zeit, in der der erste Halbleiterschalter T1 geschlossen und der zweite Halbleiterschalter offen ist und die Ausgangsspannung UA infolgedessen nahezu Null ist, einen ersten Spannungspuls UP1 der Breite tL, einen zweiten Spannungspuls UP2 der Breite tE und einen dritten Spannungspuls UP3 der Breite tV aufweist. Die Pulsbrelte tL stellt dabei die Ladezeit zum Aufladen des Kondensators C dar während die Pulsbreite tV die Verzögerungszeit ab einem definierten Triggerereignis, beispielsweise der fallenden Signalflanke des Spannungspulses UP3, bis zum Einschaltzeitpunkt t10 des zweiten Halbleiterschalters T2 und die Pulsbreite tE die Einschaltzeltdauer t10 - t11 des zweiten Halbleiterschalters T2 vorgibt.

Zur Erzeugung des ersten Spannungspulses UP1 wird der Schalter SW bei leitendem ersten Transistor T1 und sperrendem zweiten Transistor T2 für die Zeitdauer tL geschlossen und somit die Betriebsspannung U0 an den Anschlußpin P13 angelegt. Die Amplitude des Spannungspulses UP1 ist so groß, daß die Dioden HVD und D hierdurch in Durchlaßrichtung vorgespannt werden und somit ein Stromkreis von der Betriebsspannungsquelle UB über den Schalter SW, die Dioden HVD und D, den Kondensator C und den ersten Transistor T1 zurück zur Betriebsspannungsquelle UB geschlossen wird. Durch diesen Stromkreis fließt der den Kondensator C aufladende Ladestrom IL. Nach dem Öffnen des Schalters SW wird - wiederum bei leitendem ersten Transistor T1 und sperrendem zweiten Transistor T2 - dem Anschlußpin P13 über den Stromausgang AT11 der Auswerte/Treibereinheit AT1 zunächst der zweite Spannungspuls UP2 und daraufhin der dritte Spannungspuls UP3 zugeführt. Die Amplituden dieser Spannungspulse UP2, UP3 sind - beispielsweise um den Faktor 2 - kleiner als die Amplitude des ersten Spannungspulses UP1. Sie reichen zwar aus, um die Diode HVD in Durchlaßrichtung vorzuspannen, sind jedoch aufgrund des bereits aufgeladenen Kondensators C zu klein, um auch die Entkopplungsdiode D in Durchlaßrichtung vorzuspannen. Infolgedessen fließt der durch die Spannungspulse UP2, UP3 bewirkte Signalstrom IS von der Auswerte/Treibereinheit AT1 über die Diode HVD, den Ableitwiderstand RA und den ersten Transistor T1 zum ersten Spannungsversorgungsanschluß M ab. Die am Ableitwiderstand RA abfallende Spannung US wird im ersten Komparator K1 mit einer in der zweiten Steuereinheit S2 erzeugten ersten Referenzspannung UR1 verglichen. Anhand des Ergebnisses dieses Vergleichs erkennt die Auswerte/Treibereinheit AT2, ob am Anschlußpin P23 der Ladestrom IL oder der Signalstrom IS ansteht. Die Spannungspulse UP2, UP3 werden somit eindeutig dem Signalstrom IL zugeordnet und deren Pulsbreiten tE und tV zur Bestimmung der Schaltzeltpunkte t10, t11 des zweiten Transistors T2 ausgewertet.

Der zweite Transistor T2 ist über einen Widerstand R mit dem Schaltungsausgang A verbunden. Die an diesem Widerstand R abfallende Spannung UM ist ein Maß des durch den zweiten Transistor T2 fließenden Stromes und wird über den Anschlußpin P24 dem zweiten Komparator K2 zugeführt. Um den zweiten Transistor T2 vor zu hohen Strömen zu schützen, wird dieser, sobald die Spannung UM eine in der zweiten Steuereinheit S2 erzeugte zweite Referenzspannung UR2 überschreitet, durch die Auswerte/Treibereinheit AT2 ausgeschaltet.

Im vorliegenden Ausführungsbeispiel wird der Signalstrom IS zur Übertragung der Steuerinformationen pulsweitenmoduliert. Denkbar ist jedoch auch eine digitale Übertragung der Steuerinformationen. Außerdem ist es denkbar am Anschlußpin P13 Spannungspulse gleicher Amplitude bereitzustellen. Diese lassen sich dann beispielsweise über die fest vorgegebene Reihenfolge ihrer Signalflanken dem Ladestrom IL oder dem Signalstrom IS eindeutig zuordnen. Des weiteren sind Schaltungsanordnungen denkbar, bei denen der Signalstrom IS in der zweiten Steuereinheit S2 dem Kondensator C zugeführt wird, so daß der Signalstrom IS gleichzeitig ab Ladestrom IL fungiert.

## Patentansprüche

1. Schaltungsanordnung mit einer ersten Steuereinheit (S1) zur Ansteuerung eines einen Schaltungsausgang (A) mit einem ersten Spannungsversorgungsanschluß (M) verbindenden ersten Halbleiterschalters (T1) und mit einer zweiten Steuereinheit (S2) zur Ansteuerung eines den Schaltungsausgang (A) mit einem zweiten Spannungsversorgungsanschluß (V+) verbindenden zweiten Halbleiterschalters (T2), dadurch gekennzeichnet, daß
- eine Betriebsspannungsquelle (UB) zur Spannungsversorgung der ersten Steuereinheit (S1) vorgesehen ist,
- ein wiederaufladbarer Energiespeicher (C) zur Spannungsversorgung der zweiten Steuereinheit (S2) vorgesehen ist,
- die Betriebsspannungsquelle (UB) mit einem Anschluß an den ersten Spannungsversorgungsanschluß (M) angeschlossen ist,
- der Energiespeicher (C) mit einem Anschluß an den Schaltungsausgang (A) der Schaltungsanordnung angeschlossen ist,
- die Steuereinheiten (S1, S2) über eine durch die erste Steuereinheit (S1) schaltbare Schalteinheit (HVD) miteinander verbunden sind, über welche ein Strom (ILS) zum Aufladen des Energiespeichers (C) und zur Übertragung von Steuerinformationen von der ersten Steuereinheit (S1) der zweiten Steuereinheit (S2) zuführbar ist.

2. Schaltungsanordnung nach Anspruch 1, dadurch gekennzeichnet, daß der Strom (ILS) durch die Schalteinheit (HVD) einen durch die erste Steuereinheit (S1) festgelegten Signalverlauf aufweist, und daß er anhand seines Signalverlaufs von der zweiten Steuereinheit (S2) entweder als Ladestrom (IL) zum Aufladen des Energiespeichers (C) oder als Signalstrom (IS) zur Übertragung der Steuerinformationen identifizierbar ist.

3. Schaltungsanordnung nach Anspruch 1 oder 2, dadurch gekennzeichnet, daß die Schalteinheit (HVD) bei geschlossenem ersten Halbleiterschalter (T1) und offenem zweiten Halbleiterschalter (T2) schaltbar ist und bei offenem ersten Halbleiterschalter (T1) und geschlossenem zweiten Halbleiterschalter (T2) offen ist.

4. Schaltungsanordnung nach einem der vorherigen Ansprüche, dadurch gekennzeichnet, daß die Schalteinheit (HVD) als Diode ausgebildet ist.

5. Schaltungsanordnung nach einem der vorherigen Ansprüche, dadurch gekennzeichnet, daß die Halbleiterschalter (T1, T2) als Transistoren ausgebildet sind.

6. Schaltungsanordnung nach Anspruch 5, dadurch gekennzeichnet, daß die Halbleiterschalter (T1, T2) als Feldeffekttransistoren ausgebildet sind.

7. Schaltungsanordnung nach einem der vorherigen Ansprüche, dadurch gekennzeichnet, daß zwischen den Spannungsversorgungsanschlüssen (V+, M) eine hohe Versorgungsspannung (U+) anliegt und daß die Schalteinheit (HVD) und die Halbleiterschalter (T1, T2) eine hohe Spannungsfestigkeit aufweisen.

8. Schaltungsanordnung nach einem der vorherigen Ansprüche, dadurch gekennzeichnet, daß der Energiespeicher (C) als Kondensator ausgebildet ist.
